# EUROPÄISCHE PATENTSCHRIFT

(11) **EP 3 997 790 B1**
(45) Veröffentlichungstag und Bekanntmachung des Hinweises auf die Patenterteilung: **15.01.2025**
(21) Anmeldenummer: 20730624.2
(22) Anmeldetag: 04.06.2020
(51) Int. Cl.: H03K 17/041, H03K 17/16

(54) **SCHALTUNGSANORDNUNG ZUM SCHALTEN VON SCHALTELEMENTEN**
CIRCUIT ARRANGEMENT FOR SWITCHING SWITCH ELEMENTS
ENSEMBLE CIRCUIT SERVANT À COMMUTER DES ÉLÉMENTS DE COMMUTATION

(30) Priorität: 09.07.2019 DE 102019210104
(43) Veröffentlichungstag der Anmeldung: 18.05.2022
(73) Patentinhaber: Robert Bosch GmbH, 70442 Stuttgart (DE)
(72) Erfinder: RICHTER, Tobias, 74321 Bietigheim-Bissingen (DE); KAISER, Alexander, 72355 Schoerzingen (DE); SCHOLLBACH, Moritz, 72076 Tuebingen (DE); SINN, Peter, 74199 Untergruppenbach (DE)
(86) Internationale Anmeldenummer: PCT/EP2020/065481
(87) Internationale Veröffentlichungsnummer: WO 2021/004703

(56) Entgegenhaltungen:
- EP-A1- 2 632 048
- WO-A2-2007/137268
- US-A1- 2014 285 241

## Beschreibung

Die vorliegende Erfindung betrifft eine Schaltungsanordnung zum Schalten eines Schaltelements, aufweisend eine Ansteuerschaltung, die eingerichtet ist, eine von dem Schaltzustand des Schaltelements abhängige variable Voransteuerspannung bereitzustellen.

### Stand der Technik

Transistoren wie z.B. IGBTs oder andere Halbleiter-Schaltelemente werden üblicherweise mit festen Spannungen angesteuert. Das bedeutet insbesondere, dass an einen Gateanschluss eines Schaltelementes eine erste Spannung zum Einschalten des Schaltelements angelegt wird und eine zweite Spannung an den Gateanschluss des Schaltelementes zum Ausschalten angelegt wird. Solange sich der Schaltzustand nicht ändern soll, bleibt die jeweilige erste oder zweite Spannung an dem Gateanschluss angelegt. Bei einer unipolaren Versorgungsspannung werden beispielsweise 0 V zum Sperren, oder Ausschalten, und +15 V zum leitend Schalten, oder Einschalten, eines Transistors an den Gateanschluss angelegt. Bei einer bipolaren Versorgung wird eine negative Spannung, z.B. -8 V oder -15 V, verwendet, oder insbesondere an den Gateanschluss angelegt, um den Transistor zu sperren, und +15 V, um ihn leitend zu schalten. Die Spannungen werden meist durch äußere Größen wie z.B. der wirksamen Emitterinduktivität und der jeweiligen Schwellenspannung des Schaltelements bestimmt.

Beim Umschalten oder Schalten, insbesondere in dem Zwischenzustand zwischen einem Einschaltzustand und einem Ausschaltzustand, oder umgekehrt, der Schaltelemente entstehen Schaltverluste. Insbesondere wird dadurch die Leistungsfähigkeit einer Schaltung aufgrund der entstehenden Wärme und der geringeren für den elektrischen Verbraucher zur Verfügung stehenden Menge an Energie verringert. Die Wärme kann zusätzlich zu einer schnelleren Alterung der Schaltelemente führen, wodurch ein kürzerer Wartungszyklus der Geräte, in denen sie eingesetzt werden, bedingt sein kann.

Es ist daher eine Aufgabe der Erfindung, die Schaltverluste beim Schalten der Schaltelemente zu verringern und die Wirtschaftlichkeit zu erhöhen.

Aus den Dokumenten WO 2007/137268 A2, EP 2 632 048 A1 und US 2014/285241 A1 sind Schaltungsanordnungen zum Schalten eines Schaltelements bekannt.

### Offenbarung der Erfindung

Gemäß einem ersten Aspekt wird eine Schaltungsanordnung, die eine Ansteuerschaltung und ein Schaltelement, insbesondere einen Halbleiterbaustein, aufweist, vorgeschlagen. Die Schaltungsanordnung ist zum Umschalten zwischen einem ersten und einem zweiten Schaltzustand des Schaltelements eingerichtet. Die Ansteuerschaltung ist eingerichtet, eine von dem Schaltzustand des Schaltelements abhängige variable Voransteuerspannung bereitzustellen, wobei die Voransteuerspannung eine Spannung ist, die während einem der beiden Schaltzustände als Ansteuerspannung an den Steueranschluss des Schaltelements angelegt ist, und wobei die Ansteuerschaltung eingerichtet ist, die Voransteuerspannung während einem Schaltzustand zu variieren, ohne dass sich der Schaltzustand dabei ändert, insbesondere von dem ersten zu dem zweiten Schaltzustand oder umgekehrt.

In dieser Offenbarung wird der Begriff "Phase" für die Zeitdauer, in der sich der Transistor in einem Schaltzustand, also leitend oder sperrend, befindet, verwendet. Diese Phasen werden stets beim Umschalten von Zwischenzuständen unterbrochen, die zeitlich zwischen dem Einschaltzustand und dem Ausschaltzustand, oder umgekehrt, liegen. Die Voransteuerspannung ist eine Spannung, die als Ansteuerspannung verwendet werden kann, z.B. innerhalb einer der beiden Phasen. Wird sie dazu verwendet, den Transistor leitend zu schalten, wird diese spezielle Ansteuerspannung hier als Leitendansteuerspannung bezeichnet. Wird sie dazu verwendet, den Transistor zu sperren, wird diese spezielle Ansteuerspannung hier als Sperransteuerspannung bezeichnet. Die variable Voransteuerspannung kann beispielsweise von einem ersten Spannungswert auf einen zweiten Spannungswert erhöht werden oder umgekehrt abgesenkt werden. Somit bezieht sich die Variabilität der Vorsteuerspannung beispielsweise zweistufig auf zwei Spannungswerte, sie kann jedoch auch dreistufig oder mehrstufig oder kontinuierlich variabel ausgelegt sein. Mit zunehmender Variabilität kann die Anpassung der Voransteuerspannung an spezifische Arbeitspunkte des Schaltelements optimiert werden, insbesondere zur Minimierung der Schaltverluste. Weiterhin werden die Begriffe "Halbleiter" und "Halbleiterbaustein" äquivalent verwendet.

Die Ansteuerspannung, welche an einen Steueranschluss eines Schaltelements angelegt wird, ist z.B. die Gate-Emitter-Spannung eines Transistors. Die Voransteuerspannung kann z.B. eine Sperransteuerspannung sein, die, wenn sie als Ansteuerspannung geschaltet ist, den Transistor sperrt. Solange der Transistor leitend geschaltet ist, ist sie vom Transistor getrennt und hat keine aktive Funktion. An dem Gate-Eingang liegt in dieser leitenden Phase eine zweite, ausreichend positive Voransteuerspannung, die Leitendansteuerspannung, an. Durch die Einführung einer Voransteuerspannung, die z.B. eine Sperransteuerspannung zur Verfügung stellt, können Schaltverluste reduziert werden. Die Sperransteuerspannung ist in der Regel eine nicht positive Spannung oder eine Spannung unterhalb eines Schaltschwellwertes am Gate-Steuereingang des Schaltelements, wie z.B. eines Transistors. Sie liegt nur dann am Steueranschluss eines Schaltelements an, wenn das Schaltelement sperren soll. Da die Sperransteuerspannung in der leitenden Phase vom Steueranschluss des Schaltelements getrennt ist, kann sie in dieser Phase konditioniert oder variiert und voreingestellt werden, d.h. bereits a-priori so eingestellt werden, dass der Schaltverlust beim Schalten oder Umschalten in die Sperrphase verringert wird.

Gemäß einer Ausführungsform ist die Ansteuerschaltung eingerichtet, während des ersten Schaltzustands des Schaltelements die Voransteuerspannung zu verändern, z.B. zu verringern, und während des zweiten Schaltzustands des Schaltelements die Voransteuerspannung zu verändern, z.B. zu erhöhen. Der erste Schaltzustand kann ein Zustand sein, in dem das Schaltelement leitet. Der zweite Schaltzustand kann dann ein Zustand sein, in dem das Schaltelement sperrt. Ist das Schaltelement leitend, wird also z.B. die Sperransteuerspannung, die in dieser Phase nicht am Steueranschluss des Schaltelements oder Gate-Steuereingang anliegt, abgesenkt, um ein optimales Ausschalten des Transistors zu gewährleisten. Während das Schaltelement sperrt, wird die Sperransteuerspannung, die in dieser Phase am Steueranschluss des Schaltelements anliegt, angehoben, um ein optimales Einschalten zu gewährleisten. In diesem Fall wird also die Sperransteuerspannung konditioniert.

Zum Konditionieren der Leitendansteuerspannung wird die Leitendansteuerspannung während der leitenden Phase, in der sie Steueranschluss des Schaltelements anliegt, abgesenkt, um ein optimales Ausschalten des Transistors zu gewährleisten. Während das Schaltelement sperrt, wird die Leitendansteuerspannung, die in dieser Phase nicht am Steueranschluss des Schaltelements anliegt, angehoben, um ein optimales Leitendschalten zu ermöglichen.

Gemäß einer Ausführungsform ist die Ansteuerschaltung eingerichtet, während des ersten Schaltzustands des Schaltelements die Voransteuerspannung von einem ersten Wert auf einen zweiten Wert zu verringern, und während des zweiten Schaltzustands des Schaltelements die Voransteuerspannung von dem zweiten Wert auf den ersten Wert zu erhöhen. Wenn die Voransteuerspannung eine Sperransteuerspannung zum Sperren des Schaltelements ist, liegen der erste Wert der Sperransteuerspannung V_offa und der zweite Wert der Sperransteuerspannung V_offb in einem Bereich zwischen V_th und V_min, beispielsweise - 20 V, wobei V_th höher oder gleich V_offa ist, und V_offa höher als V_offb ist. V_th ist der Schaltschwellwert des Schaltelements, über dem das Schaltelement leitend wird. V_min ist die minimal zulässige Ansteuerspannung des Schaltelements. Wenn die Voransteuerspannung eine Leitendansteuerspannung zum Leitendschalten des Schaltelements ist, liegen der erste Wert der Leitendansteuerspannung V_ona und der zweite Wert der Sperransteuerspannung V_onb in einem Bereich zwischen V_max und V_th, wobei V_max höher oder gleich V_ona ist, und V_ona höher als V_onb ist. V_max ist die maximal zulässige Ansteuerspannung des Schaltelements.

Beispielsweise ist der erste Wert der Sperransteuerspannung V_offa = 0 V und der zweite Wert der Sperransteuerspannung V_offb = -8 V. Während des zweiten Zustands, dem Sperrend-Schaltzustand des Schaltelements, schaltet die Ansteuerschaltung die Sperransteuerspannung somit von -8 V auf 0 V, um das Umschalten mit einer Ansteuerspannung V_ona, z.B. +15 V, auf den Leitend-Schaltzustand zu konditionieren. Dadurch, dass die Ansteuerspannung von 0 V auf V_ona geschaltet wird anstatt von -8 V auf V_ona wird der Schaltverlust signifikant verringert. Die Sperransteuerspannung kann, abhängig vom Schaltelement oder Halbleitertyp auch niedrige positive Werte annehmen. So kann die Spannung V_offa z.B. +1 V betragen, bei der das Schaltelement weiterhin sperrt. Allgemein kann der Wert V_th, bei dem das Schaltelement noch sperrt, dem Datenblatt des Schaltelements entnommen werden. Ein weiterer typischer Wert für V_offb ist z.B. -15 V. Ein typischer Bereich der Sperransteuerspannung kann als V_th > Sperrspannung > V_min, beispielsweise -20 V, angegeben werden.

Die Änderung der variablen Voransteuerspannungswerte kann auch in mehreren Zwischenschritten erfolgen. Der Übergang von einem
Voransteuerspannungswert zum anderen kann innerhalb der physikalischen Grenzen sprungförmig, rampenförmig oder kurvenförmig erfolgen.

Gemäß einer weiteren Ausführungsform weist die Ansteuerschaltung einen Schalter auf, der eingerichtet ist, die Sperransteuerspannung von z.B. V_offa auf V_offb, bzw. umgekehrt, zu ändern und die Leitendansteuerspannung von z.B. V_onb auf V_ona, bzw. umgekehrt, zu verändern. Als Schalter sind hier vorzugsweise elektronische Schalter, wie z.B. Transistoren, zu verstehen. Ein elektronischer Schalter kann auch eine Anordnung mit mehreren elektronischen Bauteilen, z.B. eine Stromquelle, umfassen.

Gemäß einem Ausführungsbeispiel ist die Ansteuerschaltung eingerichtet, die Sperransteuerspannung während der Leitend-Phase, insbesondere kurz nach Eintreten in die Leitend-Phase auf V_offb, z.B. -8 oder auf -15 V, zu schalten. Somit ist das Schaltelement sofort wieder für ein konditioniertes Schalten in die Sperrend-Phase bereit.

Gemäß einem Ausführungsbeispiel ist die Ansteuerschaltung eingerichtet, die Sperransteuerspannung während der Sperrend-Phase, insbesondere kurz vor Eintreten in die Leitend-Phase, auf V_offa, z.B. 0 V zu schalten. Somit ist das Schaltelement in einem Großteil der Sperrend-Phase mit z.B. -8 V oder -15 V sicher gesperrt.

Entsprechend können auch die Zeitpunkte für die Leitendansteuerspannung gewählt werden. Die Schaltvorgänge der Vorkonditionierung können auch zu anderen Zeitpunkten während einer leitenden oder sperrenden Phase des Schaltelements stattfinden.

Gemäß einer weiteren Ausführungsform handelt es sich bei dem Schaltelement oder Halbleiterbaustein um einen Leistungstransistor. Beispielsweise handelt es sich um einen IGBT (Insulated Gate Bipolar Transistor) oder einen FET (Feldeffekttransistor), wie z.B. einen MOSFET (Metall-Oxid-FET).

Gemäß einem zweiten Aspekt wird ein Verfahren zum Ansteuern eines Schaltelements während eines Betriebs bereitgestellt, wobei das Schaltelement zwei Schaltzustände aufweist, wobei die unterschiedlichen Schaltzustände durch die Ansteuerung des Schaltelements mit einer Ansteuerspannung eingestellt werden. Insbesondere wird in mindestens einem der beiden Schaltzustände eine variable Voransteuerspannung als Ansteuerspannung an den Steueranschluss angelegt. In einem ersten Schritt erfolgt das Bereitstellen einer ersten Voransteuerspannung und einer zweiten Voransteuerspannung. In einem zweiten Schritt wird die zweite Voransteuerspannung an einen Steueranschluss des Schaltelements angelegt, um das Schaltelement in einen ersten Schaltzustand zu schalten. Insbesondere kann die erste Voransteuerspannung hierbei variabel sein, und die zweite Voransteuerspannung variabel oder konstant. Im dritten Schritt wird die erste Voransteuerspannung des Schaltelements verringert, während sich das Schaltelement im ersten Schaltzustand befindet. In einem vierten Schritt wird die erste Voransteuerspannung als Ansteuerspannung an den Steueranschluss des Schaltelements angelegt, um das Schaltelement in einen zweiten Schaltzustand zu schalten. In einem fünften Schritt wird die erste Voransteuerspannung erhöht, während sich das Schaltelement im zweiten Schaltzustand befindet. In einem sechsten Schritt wird die zweite Voransteuerspannung als Ansteuerspannung an den Steueranschluss des Schaltelements angelegt.

Gemäß einem Ausführungsbeispiel kann das Verfahren für eine variable Sperransteuerspannung angewandt werden, so dass während der Leitend-Phase die Sperransteuerspannung V_off von z.B. 0 V auf -15 V reduziert wird und in der Sperrphase, wenn also V_off am Steueranschluss anliegt, von -15 V auf 0 V erhöht wird. Beispielsweise weist die Schaltungsordnung für die variable Sperransteuerspannung einen Schalter im negativen Zweig zum Umschalten zwischen V_offa und V_offb auf und z.B. eine konstante Ansteuerspannung V_on im positiven Zweig.

Gemäß einem Ausführungsbeispiel kann das Verfahren für eine variable Leitendansteuerspannung angewandt werden, so dass während der Leitend-Phase die Leitendansteuerspannung V_on von z.B. 15 V auf 8 V reduziert wird und in der Sperrphase, wenn also V_on nicht am Gate-Eingang anliegt, von 8 V auf 15 V erhöht wird. Beispielsweise weist die Schaltungsanordnung für die variable Leitendansteuerspannung einen Schalter im positiven Zweig zum Umschalten zwischen V_ona und V_onb auf und z.B. eine konstante Spannung V_off im negativen Zweig.

Gemäß einer Ausführungsform können beide Verfahrensvarianten kombiniert werden. In diesem Fall wäre beispielsweise sowohl im negativen Zweig als auch im positiven Zweig ein Schalter vorhanden, so dass anstelle der konstanten Spannungen V_on bzw. V_off variable Ansteuerspannung geschaltet werden können. Somit weist der Schritt des Verringerns der ersten Voransteuerspannung des Schaltelements, während sich der Schaltelement im ersten Schaltzustand befindet, zusätzlich das Verringern der zweiten Voransteuerspannung des Schaltelements auf; und der Schritt Erhöhen der ersten Voransteuerspannung, während sich der Schaltelement im zweiten Schaltzustand befindet, weist ferner das Erhöhen der zweiten Voransteuerspannung auf.

Gemäß einem dritten Aspekt wird ein Wechselrichter mit einer Schaltungsanordnung zum Schalten eines Schaltelements bereitgestellt, aufweisend eine Ansteuerschaltung, die eingerichtet ist, eine von dem Schaltzustand des Schaltelements abhängige, variable Voransteuerspannung bereitzustellen. Insbesondere Wechselrichter, die für große Leistungen eingesetzt werden, wie z.B. in Elektrofahrzeugen, weisen Schaltelemente wie z.B. IGBTs auf, die z.B. im kHz-Bereich hohe Ströme schalten. Die hierbei auftretenden Schaltverluste können durch die hier vorgeschlagene Schaltungsanordnung um etwa 10 % verringert werden. Typischerweise weist ein Wechselrichter, je nach Architektur und Anwendung, eine Vielzahl von Schaltelementen oder Halbleitern wie z.B. IGBTs auf. Unter Wechselrichter werden Gleichspannungswandler, Wechselspannungswandler und Gleich-/Wechselspannungswandler verstanden, die in Kombination mit Wicklungen oder Spulen getaktet geschaltet werden, um das Spannungsniveau und/oder die Frequenz zu wandeln.

Gemäß einem vierten Aspekt wird ein Fahrzeug mit einem Wechselrichter bereitgestellt, der eine Schaltungsanordnung zum Schalten eines Schaltelements mit einer Ansteuerschaltung aufweist, die eingerichtet ist, eine von einem ersten oder zweiten Schaltzustand des Schaltelements abhängige variable Voransteuerspannung bereitzustellen. Diese werden z.B. zur Bereitstellung der Energie für eine elektrische Maschine oder zum Laden von Batterien für den Antrieb des Fahrzeugs eingesetzt. Elektrische Fahrzeuge können Kraftfahrzeuge, LKW, Elektroboote, Flugmaschinen, Züge, Arbeitsmaschinen etc. sein.

Weitere, die Erfindung verbessernde Maßnahmen werden nachstehend gemeinsam mit der Beschreibung der bevorzugten Ausführungsbeispiele der Erfindung anhand von Figuren näher dargestellt.

### Ausführungsbeispiele

Es zeigt:
Fig. 1 eine prinzipielle Schaltungsanordnung zur Ansteuerung eines Schaltelements gemäß einem Ausführungsbeispiel,
Fig. 2 ein Diagramm der Ansteuerspannung in den Schalt- und Ansteuerphasen gemäß einem Ausführungsbeispiel,
Fig. 2a, 2b, 2c, 2d Schalterstellungen für die Ansteuerspannung in den Schalt-und Ansteuerphasen gemäß einem Ausführungsbeispiel,
Fig. 3 ein Diagramm der Ansteuerspannung in den Schalt- und Ansteuerphasen gemäß einem weiteren Ausführungsbeispiel,
Fig. 3a, 3b, 3c, 3d Schalterstellungen für die Ansteuerspannung in den Schalt-und Ansteuerphasen gemäß einem weiteren Ausführungsbeispiel,
Fig. 4 ein Flussdiagramm eines Verfahrens gemäß einem Ausführungsbeispiel,
Fig. 5 ein Fahrzeug mit einem Wechselrichter gemäß einem Ausführungsbeispiel.

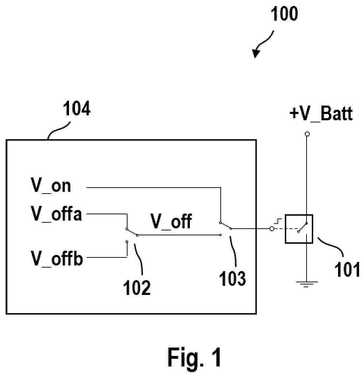

Fig. 1 zeigt eine prinzipielle Schaltungsanordnung 100 zur Ansteuerung eines Schaltelements 101, mit einer Ansteuerschaltung 104. Das in Fig. 1 gezeigte steuerbare Schaltelement 101 kann beispielsweise ein Feldeffekttransistor (FET) oder eine Variante davon sein, ein IGBT oder ein anderer Transistor- bzw. Hochleistungstransistortyp. Fig. 1 dient lediglich der Verdeutlichung der Funktionsweise der Schaltungsanordnung 100 und insbesondere der Anordnung 104. In einer realen Schaltung würde die Batteriespannung V_Batt z.B. nicht auf Masse, sondern über eine Schutzschaltung an einen Verbraucher geschaltet werden.

Fig. 1 zeigt ein einfaches Prinzip, aus dem erkennbar ist, dass mit den zwei Schaltern 103 und 102 drei Spannungsniveaus schaltbar sind. Schalter 103 wird zum Schalten der Zustände des Schaltelements verwendet (V_on, V_off), während Schalter 102 die Konditionierung oder Auswahl der Sperransteuerspannung (V_offa, V_offb) vornimmt und somit eine variable Sperransteuerungspannung ermöglicht. Die gleiche Anordnung könnte verwendet werden, um mit Schalter 102 die Konditionierung z.B. der Leitendansteuerspannung vorzunehmen (V_ona, V_onb) und mit Schalter 102 zwischen V_on und einer konstanten Spannung V_off den Schaltzustand des Schaltelements 101 einzustellen.

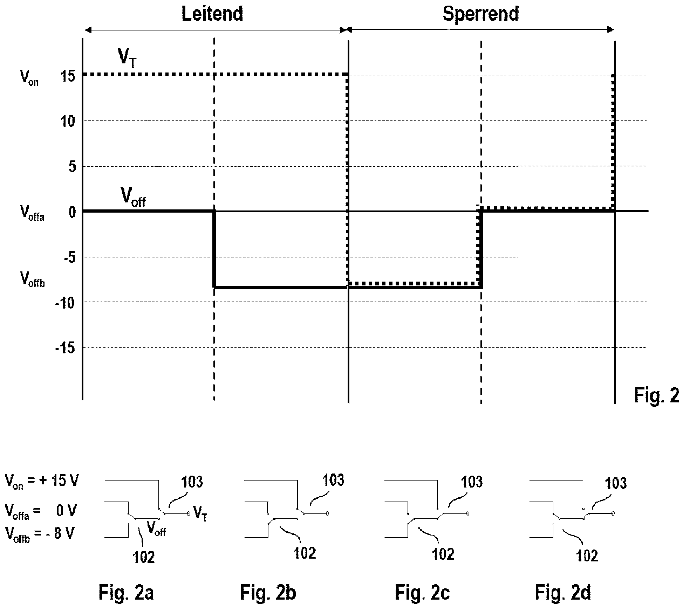

Fig. 2 zeigt beispielhaft einen Verlauf einer an den Steueranschluss angelegten Ansteuerspannung V_T oder Gate-Emitter-Spannung am Schalter 103 und den Verlauf der Sperrspannung V_off am Schalter 102. Figuren 2a bis 2d zeigen die mit den Phasen des Spannungsverlaufs in Fig. 2 korrespondieren Schalterstellungen der Schalteranordnungen. Zur einfacheren Zuordnung der Schalteranordnungen der Figuren 2a bis 2d zu den Phasen des Spannungsverlaufs in Fig. 2 sind die Spannungsübergänge idealisiert als Spannungssprünge in der Mitte einer Zustandsphase dargestellt. V_on ist in diesem Beispiel 15 V, V_offa 0 V und V_offb -8 V. Wie bereits erwähnt, können die Spannungen auch andere Werte annehmen.

Beginnend bei der Leitend-Phase in Fig. 2 und der Schalteranordnung gemäß Fig. 2a ist bei Schalterstellung des Schalters 103 nach oben zunächst auch Schalter 102 nach oben geschaltet, so dass am Schalter 102 zunächst V_offa = 0 Volt abgegriffen wird. Diese Schalterstellung des Schalters 102 ist die Schalterstellung aus der vorigen Phase. Nun wird die aktuelle Leitend-Phase in zwei Halbphasen geteilt. In der zweiten Halbphase wird Schalter 102 nach unten geschaltet, so dass V_offb = -8 V am Schalterausgang abgegriffen werden könnte oder anliegt. Sobald der Schalter 103 umgeschaltet wird, um in die Sperrend-Phase zu gelangen, liegt diese Spannung V_offb als Ansteuerspannung V_T am Steueranschluss des Schaltelements 101 an,. Somit wird in der Leitend-Phase die Sperrsteuerspannung, also die Spannung, mit der der Transistor 101 sperrend geschalten wird, eingestellt oder konditioniert, so dass das Schaltelement 101 beim Umschalten von Schalter 103 sicher sperrt. Gemäß Fig. 2c sind dann beide Schalter 102, 103 nach unten gestellt.

Nun wird aber auch die Sperrend-Phase in zwei Halbphasen geteilt. In der zweiten Halbphase wird Schalter 102 in Fig. 2d nach oben gestellt, so dass an dem Steueranschluss des Schaltelements 101 die Sperransteuerspannung V_offa = 0 Volt anliegt. Dies bewirkt, dass die Schaltverluste beim Umschalten in die leitende Phase, also entsprechend der leitenden Phase in Fig. 2a, die mit dem Schalten der positiven Spannung durch den Schalter 103 eingeleitet wird, gegenüber einem Spannungssprung von -8 V auf +15 V am Gate-Eingang verringert werden.

Die Schalter 102 und 103 können vorzugsweise elektronisch realisiert werden und beispielsweise durch einen Mikrocontroller angesteuert werden. Die Vorsteuerung kann z.B. durch Stromquellen oder umschaltbare Potentiale realisiert werden.

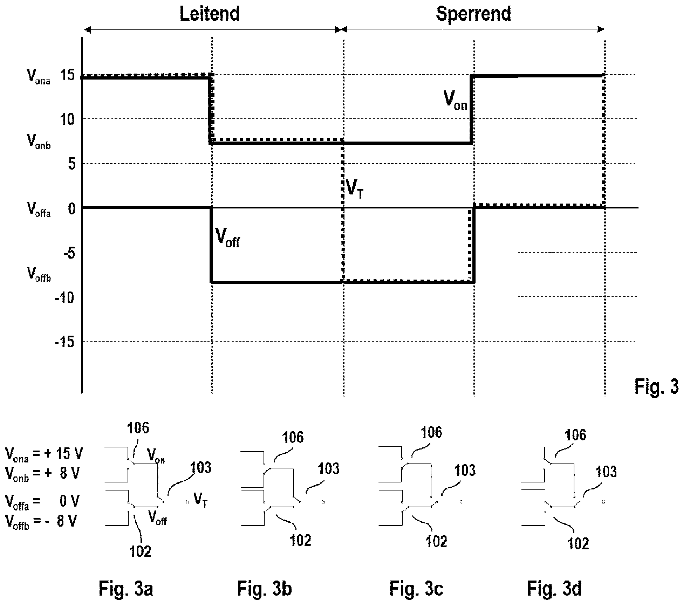

Das Diagramm in Fig. 3, und die Schaltanordnungen 3a bis 3d mit den korrespondierenden Schalterstellungen zeigen ein Beispiel, in dem die Ansteuerungsspannung sowohl für V_on als auch für V_off variabel eingestellt wird. Die Schaltungsanordnung weist nun im positiven Zweig einen Schalter 104 auf, der zwischen V_ona = +15V und V_onb = + 8 V umschalten kann. Das Schalten der Spannungen V_offa und V_offb mit resultierender Spannung V_off in Fig. 3 erfolgt in gleicher Weise wie in Fig. 2a bis 2d. In der Leitend-Phase wird nun durch das Schalten von V_ona auf V_onb die Sperrphase vorbereitet, so dass die Ansteuerspannung V_T am Steueranschluss statt von +15 V auf -8 V nunmehr von 8 V auf -8 V geschaltet wird. In der Sperrphase wird die Ansteuerspannung V_T wieder auf 15 V geschaltet, so dass ein sicherer und schneller Übergang in den Leitend-Zustand erfolgen kann. Es sei nochmals angemerkt, dass die angegebenen Spannungswerte nur beispielhaft sind.

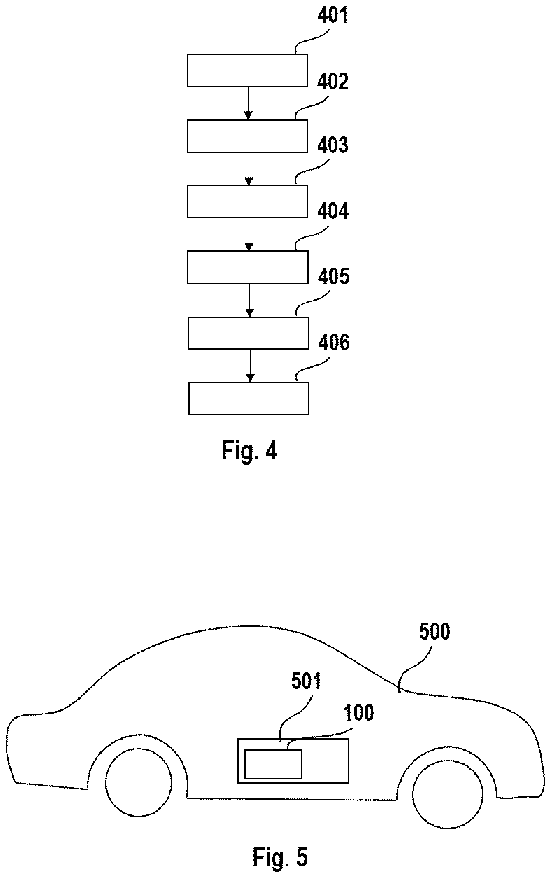

Fig. 4 zeigt ein Flussdiagramm eines Verfahrens gemäß einer Ausführung zum Ansteuern eines Schaltelements 101 während eines Betriebs, in dem das Schaltelement eine leitende und eine sperrende Phase aufweist. In einem ersten Schritt 401 wird eine Sperrsteuerspannung mit 0 V bereitgestellt. Im nächsten Schritt 402 wird das Schaltelement 101 in eine leitende Phase mit einer aktiven positiven Ansteuerspannung geschaltet. Somit springt die Spannung am Steueranschluss, z.B. die Gatespannung, lediglich von 0 V auf die positive Spannung zum Umschalten des Schaltelements 101, die z.B. 15 Volt betragen kann. In Schritt 403 wird die bereitgestellte Sperrsteuerspannung des Schaltelements während der leitenden Phase des Schaltelements verringert. In dieser Phase liegt die Sperrsteuerspannung nicht am Steueranschluss an. Die Verringerung dient der Einstellung oder Konditionierung, d.h. der Vorbereitung der nächsten Schaltphase des Schaltelements 101. In Schritt 404 wird die bereitgestellte, verringerte Sperrsteuerspannung als aktive Ansteuerspannung an den Steueranschluss angelegt, um das Schaltelement 101 in einen sperrenden Zustand zu schalten. Da die Spannung deutlich im negativen Bereich liegt, z.B. - 8 V oder -15 V, sperrt das Schaltelement optimal. Im nächsten Schritt 405 erfolgt die Vorbereitung auf die nächste leitende Phase des Schaltelements 101, indem die bereitgestellte Sperrsteuerspannung, die zu diesem Zeitpunkt noch als aktive Ansteuerspannung am Steueranschluss anliegt, auf 0 V angehoben wird. In Schritt 406 wird sodann eine positive Spannung als aktive Ansteuerspannung an den Steueranschluss angelegt, so dass das Schaltelement 101 mit weniger Verlust in die leitende Phase umschaltet.

Der Schritt 403 kann zusätzlich das Verringern der zweiten Voransteuerspannung des Schaltelements 101 aufweisen, und der Schritt 405 kann ferner das Erhöhen der zweiten Voransteuerspannung aufweisen. Das Ändern der beiden Voransteuerspannung innerhalb eines Schritts kann zu verschiedenen Zeitpunkten innerhalb der Zustandsphase, also während eines Schaltzustands, erfolgen.

Fig. 5 zeigt ein Fahrzeug 500 mit einem Wechselrichter 501 gemäß einer Ausführung, der eine oben beschriebene Schaltungsanordnung zum Ansteuern eines Schaltelements 101 aufweisen kann.

Durch die Konditionierung der Sperransteuerspannung während der Sperrend-Phase des Schaltelements 101 werden also die Verluste beim Schalten in den Leitend-Zustand verringert, und es wird aber andererseits durch Konditionierung der Sperransteuerspannung während der Leitend-Phase sichergestellt, dass der Schaltelement 101 in einen sicheren Sperrzustand geschaltet wird.

## Patentansprüche

1. Schaltungsanordnung (100), aufweisend
eine Ansteuerschaltung (104) und
einen Schaltelement (101),
wobei die Schaltungsanordnung (100) zum Umschalten zwischen einem ersten und einem zweiten Schaltzustand des Schaltelements (101) eingerichtet ist; wobei die Ansteuerschaltung (104) eingerichtet ist, eine von dem Schaltzustand des Schaltelements (101) abhängige, variable Voransteuerspannung bereitzustellen,
wobei die Voransteuerspannung eine Spannung ist, die während einem der beiden Schaltzustände als Ansteuerspannung an den Steueranschluss des Schaltelements (101) angelegt ist,
und wobei die Ansteuerschaltung (104) ferner eingerichtet ist, die Voransteuerspannung während einem Schaltzustand zu variieren, ohne dass sich der Schaltzustand ändert,
wobei der erste Schaltzustand ein Zustand ist, in dem das Schaltelement (101) leitet, und der zweite Schaltzustand ein Zustand ist, in dem das Schaltelement (101) sperrt;
wobei die Voransteuerspannung eine Sperransteuerspannung V_off ist, die dazu verwendet wird, das Schaltelement (101) zu sperren, und vom Steueranschluss des Schaltelements getrennt ist, solange das Schaltelement leitend geschaltet ist,
und wobei die Ansteuerschaltung (104) weiterhin eingerichtet ist, während des ersten Schaltzustands des Schaltelements (101) die Sperransteuerspannung V_off zu verändern,
und während des zweiten Schaltzustands des Schaltelements (101) die Sperransteuerspannung V_off zu verändern,
wobei
die Ansteuerschaltung (104) weiterhin eingerichtet ist, während des ersten Schaltzustands des Schaltelements (101) die Voransteuerspannung von einem ersten Wert auf einen zweiten Wert zu verringern,
und während des zweiten Schaltzustands des Schaltelements (101) die Voransteuerspannung von dem zweiten Wert auf den ersten Wert zu erhöhen.

2. Schaltungsanordnung (100) nach Anspruch 1,
wobei ein erster Wert der Sperransteuerspannung V_offa und ein zweiter Wert der Sperransteuerspannung V_offb in einem Bereich zwischen V_th und V_min liegen,
V_th höher oder gleich V_offa ist und V_offa höher als V_offb ist, wobei V_th der Schaltschwellwert des Schaltelements (101) ist und V_min die minimal zulässige Ansteuerspannung des Schaltelements ist.

3. Schaltungsanordnung nach einem der vorherigen Ansprüche,
wobei die Ansteuerschaltung (104) einen Schalter (102) aufweist, der eingerichtet ist, die Sperransteuerspannung, insbesondere von einem ersten Wert auf einen zweiten Wert umzuschalten.

4. Schaltungsanordnung (100) nach einem der vorherigen Ansprüche, wobei das Schaltelement (101) ein Leistungstransistor ist.

5. Verwendung der Schaltungsanordnung (100) nach einem der vorherigen Ansprüche zur Verringerung von Schaltverlusten eines Schaltelements (101).

6. Verfahren zum Ansteuern eines Schaltelements (101) während eines Betriebs,
wobei das Schaltelement zwei Schaltzustände aufweist,
wobei die unterschiedlichen Schaltzustände durch die Ansteuerung des Schaltelements mit einer Ansteuerspannung eingestellt werden, mit den Schritten:
Bereitstellen (401) einer ersten Voransteuerspannung und einer zweiten Voransteuerspannung;
Anlegen (402) der zweiten Voransteuerspannung als Ansteuerspannung an einen Steueranschluss des Schaltelements, um das Schaltelement (101) in einen ersten Schaltzustand zu schalten;
Verringern (403) der ersten Voransteuerspannung des Schaltelements (101) während sich das Schaltelement (101) im ersten Schaltzustand befindet, wobei die erste Voransteuerspannung vom Steueranschluss des Schaltelements getrennt ist;
Anlegen (404) der ersten Voransteuerspannung als Ansteuerspannung an den Steueranschluss des Schaltelements, um das Schaltelement (101) in einen zweiten Schaltzustand zu schalten;
Erhöhen (405) der ersten Voransteuerspannung während sich das Schaltelement (101) im zweiten Schaltzustand befindet;
Anlegen (406) der zweiten Voransteuerspannung als Ansteuerspannung an den Steueranschluss des Schaltelements.

7. Verfahren nach Anspruch 6,
wobei der Schritt Verringern (403) der ersten Voransteuerspannung des Schaltelements (101) während sich das Schaltelement (101) im ersten Schaltzustand befindet, zusätzlich das Verringern der zweiten Voransteuerspannung des Schaltelements (101) aufweist;
und wobei der Schritt Erhöhen (405) der ersten Voransteuerspannung während sich das Schaltelement (101) im zweiten Schaltzustand befindet, ferner das Erhöhen der zweiten Voransteuerspannung aufweist.

8. Wechselrichter (501) mit einer Schaltungsanordnung (100) zum Schalten eines Schaltelements (101) nach einem der Ansprüche 1 bis 4.

9. Fahrzeug (500) mit einem Wechselrichter (501), der eine Schaltungsanordnung (100) zum Schalten eines Schaltelements (101) nach einem der Ansprüche 1 bis 4 aufweist.

## Claims

1. Circuit arrangement (100), having
an actuation circuit (104) and
a switching element (101),
wherein the circuit arrangement (100) is designed to switch over between a first and a second switching state of the switching element (101);
wherein the actuation circuit (104) is designed to provide a variable pre-actuation voltage that is dependent on the switching state of the switching element (101),
wherein the pre-actuation voltage is a voltage that is applied to the control connection of the switching element (101) as the actuation voltage during one of the two switching states,
and wherein the actuation circuit (104) is also designed to vary the pre-actuation voltage during a switching state without the switching state changing,
wherein the first switching state is a state in which the switching element (101) is turned on and the second switching state is a state in which the switching element (101) is turned off;
wherein the pre-actuation voltage is a turn-off actuation voltage V_off that is used to turn off the switching element (101) and that is disconnected from the control connection of the switching element as long as the switching element is turned on,
and wherein the actuation circuit (104) is furthermore designed to change the turn-off actuation voltage V_off during the first switching state of the switching element (101),
and to change the turn-off actuation voltage V_off during the second switching state of the switching element (101),
wherein
the actuation circuit (104) is furthermore designed
to reduce the pre-actuation voltage from a first value to a second value during the first switching state of the switching element (101),
and to increase the pre-actuation voltage from the second value to the first value during the second switching state of the switching element (101).

2. Circuit arrangement (100) according to Claim 1,
wherein
a first value of the turn-off actuation voltage V_offa and a second value of the turn-off actuation voltage V_offb are in a range between V_th and V_min,
V_th is higher than or equal to V_offa
and V_offa is higher than V_offb, wherein V_th is the switching threshold value of the switching element (101) and V_min is the minimum permissible actuation voltage of the switching element.

3. Circuit arrangement according to either of the preceding claims, wherein the actuation circuit (104) has a switch (102) that is designed to switch the turn-off actuation voltage over, in particular from a first value to a second value.

4. Circuit arrangement (100) according to one of the preceding claims,
wherein the switching element (101) is a power transistor.

5. Use of the circuit arrangement (100) according to one of the preceding claims for reducing switching losses of a switching element (101).

6. Method for actuating a switching element (101) during operation,
wherein the switching element has two switching states,
wherein the different switching states are set by actuating the switching element with an actuation voltage, having the steps:
providing (401) a first pre-actuation voltage and a second pre-actuation voltage;
applying (402) the second pre-actuation voltage to a control connection of the switching element as the actuation voltage so as to switch the switching element (101) to a first switching state;
reducing (403) the first pre-actuation voltage of the switching element (101) while the switching element (101) is in the first switching state, wherein the first pre-actuation voltage is disconnected from the control connection of the switching element;
applying (404) the first pre-actuation voltage to the control connection of the switching element as the actuation voltage so as to switch the switching element (101) to a second switching state;
increasing (405) the first pre-actuation voltage while the switching element (101) is in the second switching state;
applying (406) the second pre-actuation voltage to the control connection of the switching element as the actuation voltage.

7. Method according to Claim 6,
wherein the step of reducing (403) the first pre-actuation voltage of the switching element (101) while the switching element (101) is in the first switching state additionally includes reducing the second pre-actuation voltage of the switching element (101);
and wherein the step of increasing (405) the first pre-actuation voltage while the switching element (101) is in the second switching state also includes increasing the second pre-actuation voltage.

8. Inverter (501) comprising a circuit arrangement (100) for switching a switching element (101) according to one of Claims 1 to 4.

9. Vehicle (500) comprising an inverter (501) that has a circuit arrangement (100) for switching a switching element (101) according to one of Claims 1 to 4.

## Revendications

1. Agencement de circuit (100), présentant
un circuit de pilotage (104), et
un élément de commutation (101),
dans lequel l'agencement de circuit (100) est conçu pour commuter entre un premier et un deuxième état de commutation de l'élément de commutation (101) ;
dans lequel le circuit de pilotage (104) est conçu pour fournir une tension de commande pilote variable, dépendant de l'état de commutation de l'élément de commutation (101),
dans lequel la tension de commande pilote est une tension qui est appliquée en tant que tension de pilotage à la borne de commande de l'élément de commutation (101) pendant l'un des deux états de commutation,
et dans lequel le circuit de pilotage (104) est en outre conçu pour faire varier la tension de commande pilote pendant un état de commutation sans que l'état de commutation ne change,
dans lequel le premier état de commutation est un état dans lequel l'élément de commutation (101) est passant, et le deuxième état de commutation est un état dans lequel l'élément de commutation (101) est bloquant ;
dans lequel la tension de commande pilote est une tension de pilotage de blocage V_off qui est utilisée pour bloquer l'élément de commutation (101), et est séparée de la borne de commande de l'élément de commutation tant que l'élément de commutation est mis à l'état passant,
et dans lequel le circuit de pilotage (104) est en outre conçu pour modifier la tension de pilotage de blocage V_off pendant le premier état de commutation de l'élément de commutation (101),
et pour modifier la tension de pilotage de blocage V_off pendant le deuxième état de commutation de l'élément de commutation (101),
dans lequel
le circuit de pilotage (104) est en outre conçu
pour diminuer la tension de commande pilote d'une première valeur à une deuxième valeur pendant le premier état de commutation de l'élément de commutation (101),
et pour augmenter la tension de commande pilote de la deuxième valeur à la première valeur pendant le deuxième état de commutation de l'élément de commutation (101).

2. Agencement de circuit (100) selon la revendication 1,
dans lequel
une première valeur de la tension de pilotage de blocage V_offa et une deuxième valeur de la tension de pilotage de blocage V_offb se trouvent dans une plage entre V_th et V_min,
V_th et supérieure ou égale à V_offa,
et V_offa est supérieure à V_offb, où V_th est la valeur seuil de commutation de l'élément de commutation (101) et V_min est la tension de pilotage admissible au minimum de l'élément de commutation.

3. Agencement de circuit selon l'une quelconque des revendications précédentes, dans lequel le circuit de pilotage (104) présente un commutateur (102) qui est conçu pour commuter la tension de pilotage de blocage en particulier d'une première valeur à une deuxième valeur.

4. Agencement de circuit (100) selon l'une quelconque des revendications précédentes,
dans lequel l'élément de commutation (101) est un transistor de puissance.

5. Utilisation de l'agencement de circuit (100) selon l'une quelconque des revendications précédentes pour diminuer les pertes de commutation d'un élément de commutation (101).

6. Procédé permettant de piloter un élément de commutation (101) pendant un fonctionnement,
dans lequel l'élément de commutation présente deux états de commutation,
dans lequel les différents états de commutation sont réglés par le pilotage de l'élément de commutation par une tension de pilotage, comprenant les étapes consistant à :
fournir (401) une première tension de commande pilote et une deuxième tension de commande pilote ;
appliquer (402) la deuxième tension de commande pilote en tant que tension de pilotage à une borne de commande de l'élément de commutation afin de commuter l'élément de commutation (101) sur un premier état de commutation ;
diminuer (403) la première tension de commande pilote de l'élément de commutation (101) pendant que l'élément de commutation (101) se trouve dans le premier état de commutation, dans lequel la première tension de commande pilote est séparée de la borne de commande de l'élément de commutation ;
appliquer (404) la première tension de commande pilote en tant que tension de pilotage à la borne de commande de l'élément de commutation afin de commuter l'élément de commutation (101) sur un deuxième état de commutation ;
augmenter (405) la première tension de commande pilote pendant que l'élément de commutation (101) se trouve dans le deuxième état de commutation ;
appliquer (406) la deuxième tension de commande pilote en tant que tension de pilotage à la borne de commande de l'élément de commutation.

7. Procédé selon la revendication 6,
dans lequel l'étape de diminution (403) de la première tension de commande pilote de l'élément de commutation (101) pendant que l'élément de commutation (101) se trouve dans le premier état de commutation présente en plus la diminution de la deuxième tension de commande pilote de l'élément de commutation (101) ;
et dans lequel l'étape d'augmentation (405) de la première tension de commande pilote pendant que l'élément de commutation (101) se trouve dans le deuxième état de commutation présente en outre l'augmentation de la deuxième tension de commande pilote.

8. Onduleur (501) comprenant un agencement de circuit (100) permettant de commuter un élément de commutation (101) selon l'une quelconque des revendications 1 à 4.

9. Véhicule (500) comprenant un onduleur (501) qui présente un agencement de circuit (100) permettant de commuter un élément de commutation (101) selon l'une quelconque des revendications 1 à 4.
